# EUROPEAN PATENT SPECIFICATION

(11) **EP 2 086 013 B1**
(45) Date of publication and mention of the grant of the patent: **23.05.2018**
(21) Application number: 09151196.4
(22) Date of filing: 23.01.2009
(51) Int. Cl.: H01L 29/786, H01L 29/49

(54) **Oxide semiconductor transistor**
Oxidhalbleitertransistor
Transistor à semi-conducteur d'oxyde

(30) Priority: 01.02.2008 KR 20080010816; 10.10.2008 KR 20080099608
(43) Date of publication of application: 05.08.2009
(73) Proprietor: Samsung Electronics Co., Ltd., Suwon-si, Gyeonggi-do, 443-742 (KR)
(72) Inventor: Son, Kyung-seok, Gyeonggi-do (KR); Kim, Tae-sang, Gyeonggi-do (KR); Kwon, Jang-yeon, Gyeonggi-do (KR); Jung, Ji-sim, Gyeonggi-do (KR); Lee, Sang-yoon, Gyeonggi-do (KR); Ryu, Myung-kwan, Gyeonggi-do (KR); Yoo, Byung-wook, Gyeonggi-do (KR); Park, Kyung-bae, Gyeonggi-do (KR)
(74) Representative: Portch, Daniel

(56) References cited:
- WO-A-2006/060521
- US-A- 5 140 391
- US-A1- 2001 030 323
- US-A1- 2002 179 908
- US-A1- 2003 025 166
- US-A1- 2003 038 288
- US-A1- 2005 199 960
- US-A1- 2006 189 049
- NOMURA K ET AL: "Room-temperature fabrication of transparent flexible thin-film transistors using amorphous oxide semiconductors" NATURE, NATURE PUBLISHING GROUP, LONDON, UK, vol. 432, no. 25, 25 November 2004 (2004-11-25), pages 488-492, XP002410190 ISSN: 0028-0836
- CAKICI T ET AL: "A low power four transistor Schmitt Trigger for asymmetric double gate fully depleted SOI devices" 2003 IEEE INTERNATIONAL SOI CONFERENCE PROCEEDINGS. NEWPORT BEACH, CA, SEPT. 29 - OCT. 2, 2003; [IEEE INTERNATIONAL SOI CONFERENCE], NEW YORK, NY : IEEE, US, 29 September 2003 (2003-09-29), pages 21-22, XP010665917 ISBN: 978-0-7803-7815-5

## Description

### BACKGROUND OF THE INVENTION

One or more embodiments relate to an oxide semiconductor transistor including an oxide semiconductor as a channel material and a method of manufacturing the same.

Thin film transistors (TFTs) have been applied in various fields. In particular, TFTs are used as switching and driving devices in display devices and as selection switches in cross point type memory devices.

Liquid crystal displays (LCDs) are mainly used as television (TV) panels. Therefore, much research has been conducted in order to apply organic light emitting displays (OLEDs) to TVs. TV display technology has been developed to satisfy the requirements of the display market, such as large-scale TVs or Digital Information Displays (DIDs), low prices, high definition (moving picture expression, high resolution, brightness, contrast ratio, color representation, etc.), etc. In order to cope with these requirements, large-sized substrates such as glass, etc., are required and TFTs for use as switching and driving devices should have high performances.

Amorphous silicon (a-Si) TFTs are used as driving and switching devices of displays, uniformly formed on large substrates having lengths of 2m at low cost, and widely used. However, such a-Si TFTs are required to have high performances in view of the tendency to increase the size and high definition characteristic of display devices. Thus, a-Si TFTs cannot have mobility higher than 0.5cm²/Vs. Accordingly, high-performance TFTs having higher mobility than a-Si TFTs and manufacturing techniques for such TFTs are required.

Since poly silicon (p-Si) TFTs have high mobility of several tens to hundreds of cm²/Vs, the p-Si TFTs are applied to high definition displays unlike the a-Si TFTs. Also, the characteristics of p-Si TFTs deteriorate much less than the characteristics a-Si TFTs. TFTs than a-Si TFTs, which increases the manufacturing costs. Therefore, p-Si TFTs are appropriate for high definition displays and products such as OLEDs. However, p-Si TFTs are inferior to a-Si TFTs in terms of cost and thus have limited applications to displays. Also, in the case of p-Si TFTs, manufacturing processes using large substrates having lengths of 1m or more have not been introduced due to limits of the manufacturing equipment and technical problems such uniformity poorness. Thus, it is difficult to apply p-Si TFTs to TV products.

Accordingly, a new TFT technology combining the advantages of a-Si TFTs and p-Si TFTs has been intensively studied, and oxide semiconductor devices have been developed.

Recently, ZnO-based TFTs have been in the spotlight as oxide semiconductor devices. Zn Oxide, Ga-In-Zn Oxide, etc., have been introduced as ZnO-based materials. Since ZnO-based semiconductor devices are manufactured using low temperature processes and have amorphous phases, ZnO-based semiconductor devices can be easily formed to have large areas. Also, ZnO-based semiconductor films have high electric characteristics like poly silicon as high mobility materials. Also, research has been conducted to use oxide semiconductor material layers having high mobility, i.e., ZnO-based material layers, in channel areas of TFTs. Zn Oxide, Ga-In-Zn Oxide, etc., are introduced as ZnO-based materials.

WO 2006/060521 describes a thin-film transistor with two gates for connection to two different lines in a pixel display device, for example using OLEDs.

US2005/199960 discloses an oxide semiconductor thin film transistor having a double gate configuration.

### SUMMARY OF THE INVENTION

One or more embodiments include a transistor including an oxide semiconductor as a channel material. Additional aspects will be set forth in part in the description which follows and, in part, will be apparent from the description, or may be learned by practice of the invention.

In a first aspect, the invention relates to an oxide semiconductor thin film transistor according to claim 1.

The first gate insulating layer is formed of a material that does not include oxygen, and the second gate insulating layer may be formed of a material that includes oxygen. The first gate insulating layer may be formed of silicon nitride, and the second gate insulating layer may be formed of silicon oxide.

The first and second gate insulating layers may be formed to different thicknesses. The first gate insulating layer may be formed to be thicker than the second gate insulating layer.

Source and drain electrodes may be formed on both sides of an upper surface or a lower surface of the channel layer.

The oxide semiconductor may be Zinc Oxide, Tin Oxide, Ga-In-Zn Oxide, In-Zn Oxide, In-Sn Oxide, or one of Zinc Oxide, Tin Oxide, Ga-In-Zn Oxide, In-Zn Oxide, and In-Sn Oxide that are doped with one of Al, Ni, Cu, Ta, Mo, Hf, and Ti.

The first gate insulating layer may be formed to be thicker than the second gate insulating layer. A thickness of the first gate insulating layer may be from about 2000Å to about 1µm, and a thickness of the second gate insulating layer may be from about 500Å to about 5000Å. The first and second gate insulating layers may be formed of different materials.

In an oxide semiconductor TFT including double gates, the double gates may be respectively formed on upper and lower surfaces of a channel layer formed of an oxide semiconductor to move a threshold voltage toward a positive direction. Also, sub-threshold slope of the oxide semiconductor TFT may be improved compared to an oxide semiconductor TFT including a single gate. Therefore, an operating current may increase at the same driving voltage. In addition, since a variation in the threshold voltage with respect to a bias voltage applying time period may be reduced, electric reliability may be improved.

These and/or other aspects will become apparent and more readily appreciated from the following description of the embodiments, taken in conjunction with the accompanying drawings of which:
FIG. 1 is a cross-sectional view of an oxide semiconductor thin film transistor (TFT) according to an embodiment;
FIG. 2 shows a graph for comparing current-voltage (I-V) characteristics of a double gate structure oxide semiconductor TFT including first and second gates that
   synchronize with each other with I-V characteristics of a single gate structure oxide semiconductor TFT;
FIG. 3 illustrates I-V characteristics of a double gate structure oxide semiconductor TFT including a second gate that is connected to an independent line, with a single gate structure oxide semiconductor TFT;
FIGS. 4A and 4B illustrate I-V characteristics of a conventional oxide semiconductor TFT including a single gate with respect to bias voltage applying time periods;
FIGS. 5A and 5B illustrate I-V characteristics of a double gate structure oxide semiconductor TFT with respect to bias voltage applying time periods, according to embodiments;
FIG. 6 is a plan view of an oxide semiconductor TFT applied to a pixel unit of a display device, according to another embodiment;
FIG. 7 is a cross-sectional view taken along line VI-VI' of FIG. 6;
FIG. 8 is a cross-sectional view taken along line VII-VII' of FIG. 6; and
FIGS. 9 through 11 are cross-sectional views illustrating a method of manufacturing an oxide semiconductor TFT, according to an embodiment.

### DETAILED DESCRIPTION

One or more embodiments provide a thin film transistor (TFT) including an oxide semiconductor as a channel material. Also, such an oxide semiconductor TFT according to the embodiments may be applied to a driving circuit unit and a pixel unit of a display device such as a liquid crystal display (LCD), an organic light emitting device (OLED), or the like. The oxide semiconductor TFT may be applied to only one of the driving circuit unit and the pixel unit.

Hereinafter, the embodiments will be described in detail with reference to the attached drawings. Like reference numerals in the drawings denote like elements. In the drawings, the sizes or thicknesses of elements are exaggerated for clarity.

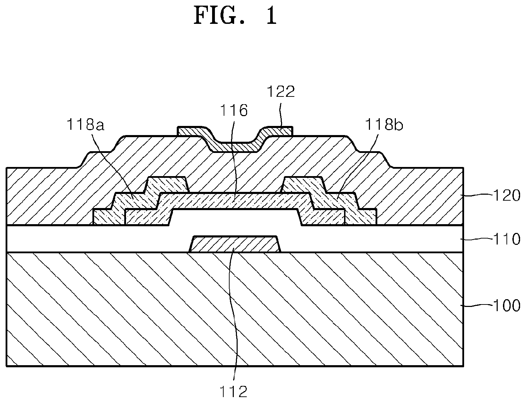

FIG. 1 is a cross-sectional view of an oxide semiconductor TFT according to an embodiment.

Referring to FIG. 1, the oxide semiconductor TFT of the present embodiment includes a channel layer 116, a first gate insulating layer 110 and a first gate 112 that are sequentially formed on a surface of the channel layer 116, and a second gate insulating layer 120 and a second gate 122 that are sequentially formed on an other surface of the channel layer 116. Here, the first and second gate insulating layers 110 and 120 may be formed of different materials. The first and second gate insulating layers 110 and 120 may also be formed to different thicknesses.

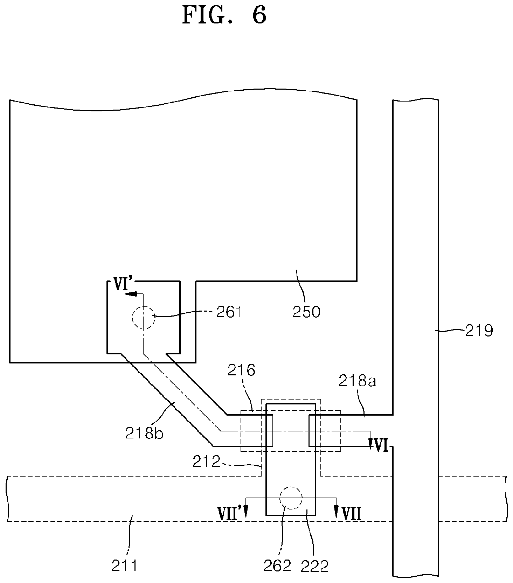

In more detail, the first gate 112 and the first gate insulating layer 110 are sequentially formed on a substrate 100. The substrate 100 is a transparent glass substrate but may be a transparent plastic substrate. The first gate 112 is formed on the substrate 100. Although not shown in FIG. 1, a gate line 211 of FIG. 6 may be formed on the substrate 100 to be electrically connected to the first gate 112 so as to apply a predetermined voltage to the first gate 112. A gate metal such as Mo or the like may be deposited on the substrate 100 and then patterned to form the first gate 112.

The first gate insulating layer 110 is formed on the substrate 100 to cover the first gate 112. In the present embodiment, the first gate insulating layer 110 may be formed of a different material from that of which the second gate insulating layer 112 is formed, wherein the second gate insulating layer 120 will be described later. In more detail, the first gate insulating layer 110 may be formed of a material that does not include oxygen, e.g., silicon nitride. The first gate insulating layer 110 may be formed to a different thickness from that to which the second gate insulating layer 120 is formed. In more detail, a thickness **d₁** of the first gate insulating layer 110 may be thicker than a thickness **d₂** of the second gate insulating layer 120. For example, the thickness **d₁** of the first gate insulating layer 110 may be within a range between about 2000Ǻ and about 1µm but is not limited thereto.

The channel layer 116 is formed of an oxide semiconductor to a predetermined thickness on the first gate insulating layer 110. The channel layer 116 is positioned above the first gate 112. The oxide semiconductor may be Zinc Oxide, Tin Oxide, Ga-In-Zn Oxide, In-Zn Oxide, In-Sn Oxide, or one of Zinc Oxide, Tin Oxide, Ga-In-Zn Oxide, In-Zn Oxide, and In-Sn Oxide that are doped with Al, Ni, Cu, Ta, Mo, Hf, or Ti. The channel layer 116 may be formed to a thickness between 10nm and 300nm but is not limited thereto. An oxide semiconductor may be deposited to a predetermined thickness on the first gate insulating layer 110 and then patterned to form the channel layer 116.

Source and drain electrodes 118a and 118b are respectively formed on both sides of an upper surface of the channel layer 116 that is formed of the oxide semiconductor. A predetermined metal layer is formed on the first gate insulating layer 110 to cover the channel layer 116 and then patterned in order to form the source and drain electrodes 118a and 118b. Here, the predetermined metal layer may have a single layer structure or a multilayer structure. The predetermined metal layer may also be formed of at least one of Cu, Mo, and Al. Differently from FIG. 1, the source and drain electrodes 118a and 118b may be formed on both sides of a lower surface of the channel layer 116. The source electrode 118a may be electrically connected to a data line 219 of FIG. 6.

The second gate insulating layer 120 is formed to a predetermined thickness on the first gate insulating layer 110 to cover the channel layer 116 and the source and drain electrodes 118a and 118b. In the present embodiment, as previously described, the second gate insulating layer 120 may be formed of a different material from that of which the first gate insulating layer 110 is formed. In more detail, the second gate insulating layer 120 may be formed of a material including oxygen, e.g., silicon oxide. The second gate insulating layer 120 may also be formed to a different thickness from that to which the first gate insulating layer 110 is formed. In more detail, the thickness **d₂** of the second gate insulating layer 120 may be thinner than the thickness **d₁** of the first gate insulating layer 110. For example, the thickness **d₂** of the second gate insulating layer 120 may be from about 500Å to about 5000Å but is not limited thereto.

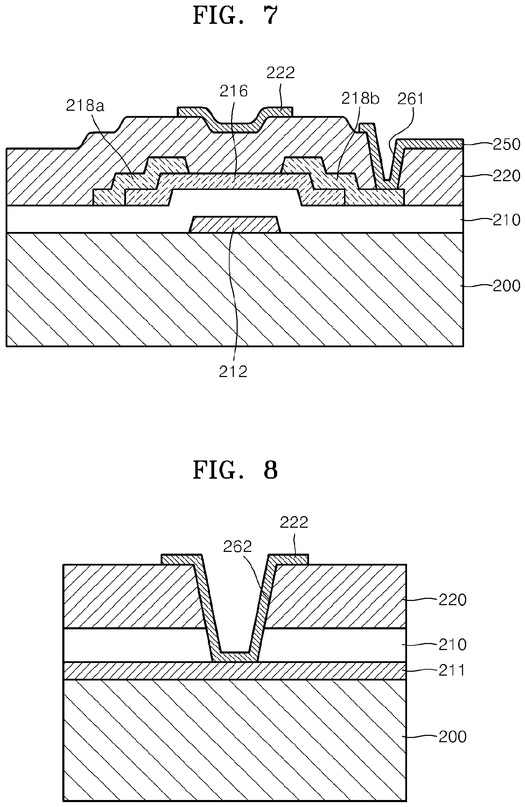

The second gate 122 is formed on the second gate insulating layer 120. The second gate 122 is positioned above the channel layer 116. The second gate 122 may be formed of the same material (e.g., Mo or the like) as that of which the first gate 112 is Tin Oxide (ITO) or Indium Zinc Oxide (IZO)) as that of which a pixel electrode 250 of FIG. 7 is formed. The Second gate 122 may be formed in a line width from about 0.08µm to about 100µm but is not limited thereto.

When a predetermined voltage is applied to the second gate 122, the second gate 122 inhibits a leakage current and increases an operating current in a turn-on state of the oxide semiconductor TFT The second gate 122 is electrically connected to the first gate 112 to electrically synchronize with the first gate 112. In this case, the second gate 122 may be electrically connected to the gate line 211 of FIG. 6 through a via hole 262 of FIG. 8 that is formed in the second gate insulating layer 120 and the first gate insulating layer 110.

In the oxide semiconductor TFT having the above-described structure, a predetermined voltage may be applied to the second gate 122 to inhibit a leakage current that flows through an upper portion of the channel layer 116 and to move a threshold voltage toward a positive direction compared to a conventional oxide semiconductor TFT. Also, when the oxide semiconductor TFT is turned on, current gains are obtained from both upper and lower portions of the channel layer 116. Thus, a sub-threshold slope or mobility is improved. Therefore, a higher operating current is obtained at the same driving voltage than in the conventional oxide semiconductor TFT.

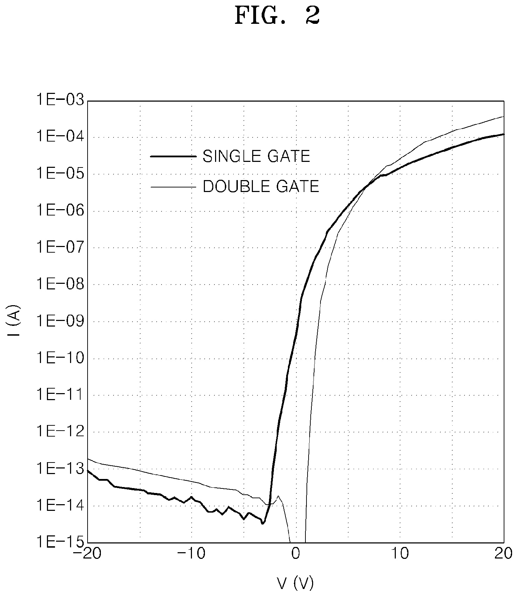

FIG. 2 shows a graph for comparing I-V characteristics of an oxide semiconductor TFT including double gates with I-V characteristics of an oxide semiconductor TFT including a single gate, according to an embodiment. Here, the I-V characteristics of the oxide semiconductor TFT including the double gates are measured when two gates electrically synchronize with each other. Also, Ga-In-Zn oxide is used as an oxide semiconductor constituting a channel layer, and first and second gate insulating layers are formed of silicon nitride and silicon oxide, respectively. The first and second gate insulating layers are also formed to thicknesses of about 4000Å and about 2000Å, respectively. A first gate electrode and source and drain electrodes are formed of Mo on a lower surface of a channel layer, and a second gate is formed of In-Zn Oxide on an upper surface of the channel layer.

Referring to FIG. 2, a threshold voltage is moved by about 1.8V toward a positive direction in the oxide semiconductor TFT including the double gates compared to the oxide semiconductor TFT including the single gate. Also, a current at a gate voltage of 0V is greatly reduced from 1nA to 1fA. This is because a leakage current flowing through an upper portion of the channel layer is restrained by the second gate formed on the second gate insulating layer. Also, in the oxide semiconductor TFTs including the single gate and the double gates, mobility is about 9.1cm²/Vs and about 32.1cm²/Vs, respectively. Therefore, the mobility of the oxide semiconductor TFT including the double gates is increased by about 3.5 times. The increase in the mobility is attributed to an effect of the second gate formed on the second gate insulating layer and an effect of the second gate insulating layer formed to a thinner thickness than the first gate insulating layer. Also, sub-threshold slopes of the oxide semiconductor TFTs including the single gate and the double gates are about 1.45 dec/V and about 1.85 dec/V, respectively. Therefore, the sub-threshold slope of the oxide semiconductor TFT including the double gates is increased by about 1.27 times compared to the oxide semiconductor TFT including single gate.

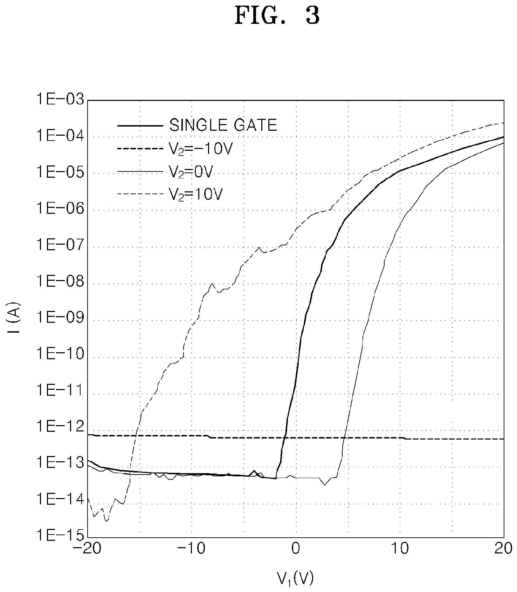

FIG. 3 shows a graph for comparing I-V characteristics of an oxide semiconductor TFT including double gates with an oxide semiconductor TFT including a single gate. Here, the I-V characteristics of the oxide semiconductor TFT including the double gates are measured when a second gate is connected to an independent line. In FIG. 3, **V₁** and **V₂** respectively denote voltages applied to first and second gates. Here, Ga-In-Zn Oxide is used as an oxide semiconductor constituting a channel layer, and first and second gate insulating layers are formed of silicon nitride and silicon oxide, respectively. Thicknesses of the first and second gate insulating layers are 4000Å and 2000Å, respectively. A first gate and lower surface of the channel layer, a second gate is formed of In-Zn Oxide on an upper surface of the channel layer.

Referring to FIG. 3, when the voltage **V₂** of the second gate is -10V, the oxide semiconductor TFT is constantly turned off at the voltage **V₁** of the first gate between -20V and 20V. However, when the voltage **V₂** of the second gate is +10V, a threshold voltage moves toward a negative direction and an operating current increases, compared tο the oxide semiconductor TFT including the single gate. Also, when the voltage **V₂** of the second gate is 0V, the threshold voltage is moved by about 7V toward a positive direction, compared to the oxide semiconductor TFT including the single gate. As described above, in an oxide semiconductor TFT according to Figure 3; I-V characteristics depends more on a second gate than a first gate. This is because an oxide semiconductor TFT manufactured in the present experiment has the follow structure. A channel layer is formed of an oxide semiconductor to a thin thickness of about 700Å, and thus an electric field formed by first and second gates affects both upper and lower portions of the channel layer. Also, a first gate insulating layer is formed of a silicon nitride layer having a thickness of about 4000Å, and a second gate insulating layer is formed of a silicon oxide layer having a thickness of about 2000Å. Thus, a capacitance of the second gate insulating layer is greater than capacitance of the first gate insulating layer. As a result, it is observed that an effect of the second gate is high. Therefore, a thickness and a dielectric constant of the second gate insulating layer are adjusted to change the effect of the second gate. In more detail, when the capacitance of the second gate insulating layer becomes greater than the capacitance of the first gate insulating layer, the effect of the second gate increases. Also, when a thickness of the channel layer becomes thinner, and a line width of the second gate increases, the effect of the second gate increases. Accordingly, in the oxide semiconductor TFT including the double gates, at least one of the voltage applied to the second gate, the thickness of the channel layer, the thickness and dielectric constant of the second gate insulating layer, and the line width of the second gate is adjusted to change the effect of the second gate. As a result, the threshold voltage is controlled. In the oxide semiconductor TFT including double gates, a back channel area of oxide semiconductor is plasma-damaged during a source-drain electrode patterning process, a photoresist ashing process, and a second gate insulating layer depositing process, a photoresist ashing process, and a second gate insulating layer depositing process. Thus, a leakage current increases, and a variation in the threshold voltage increases during applying of a bias voltage due to an increase in a trap site caused by the plasma damage. Therefore, an electric field of the second gate is adjusted to inhibit the leakage current and charge trapping. A reduction in the leakage current and an improvement of reliability, which are to be achieved through the adjustment of the electric field of the second gate, may be realized by reducing the thickness of the second gate insulating layer and applying the same voltage to the second gate as the first gate.

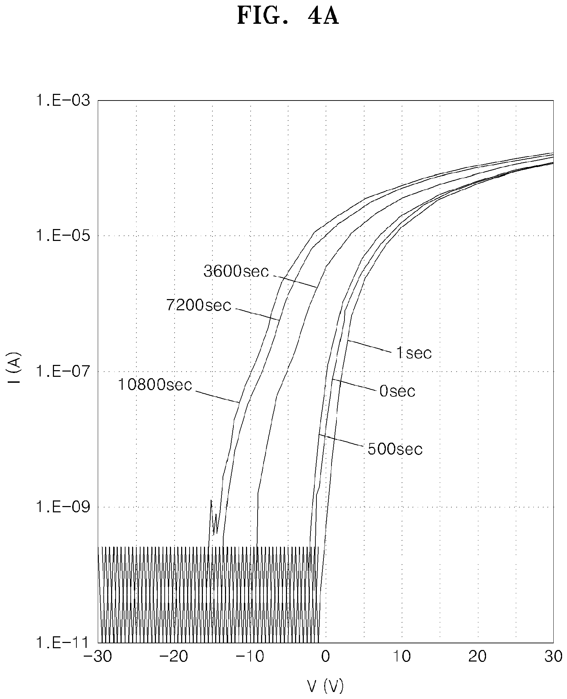

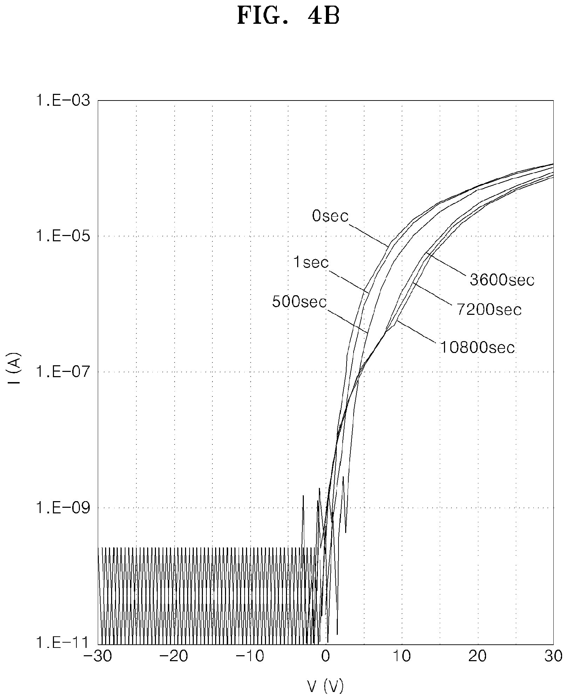

FIGS. 4A and 4B illustrate I-V characteristics of a conventional oxide semiconductor TFT including a single gate with respect to bias voltage applying time periods. In more detail, FIG. 4A illustrates the I-V characteristics of the conventional oxide semiconductor TFT including the single gate with respect to an applying time period of a negative bias voltage (DC -20V) that is applied between a gate and a source electrode at a temperature of 60°C. Also, FIG. 4B illustrates the I-V characteristics of the conventional oxide semiconductor TFT including the single gate with respect to an applying time period of a positive bias voltage (DC +20) that is applied between the gate and the source electrode at the temperature of 60°C. Here, Ga-In-Zn Oxide is used as an oxide semiconductor constituting a channel layer. Also, first and second gate insulating layers are formed of silicon nitride and silicon oxide, respectively, and the gate, the source electrode, and a drain electrode are formed of Mo.

Referring to FIGS. 4A and 4B, in the conventional oxide semiconductor TFT including the single gate, after the negative bias voltage is applied for 3 hours, a threshold voltage is changed by about -9.7V. After the positive bias voltage is applied for 3 hours, the threshold voltage is changed by +6.6V.

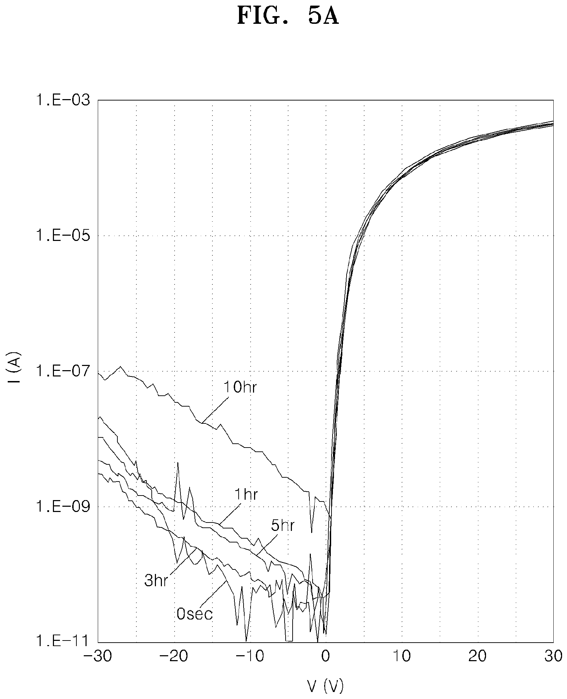

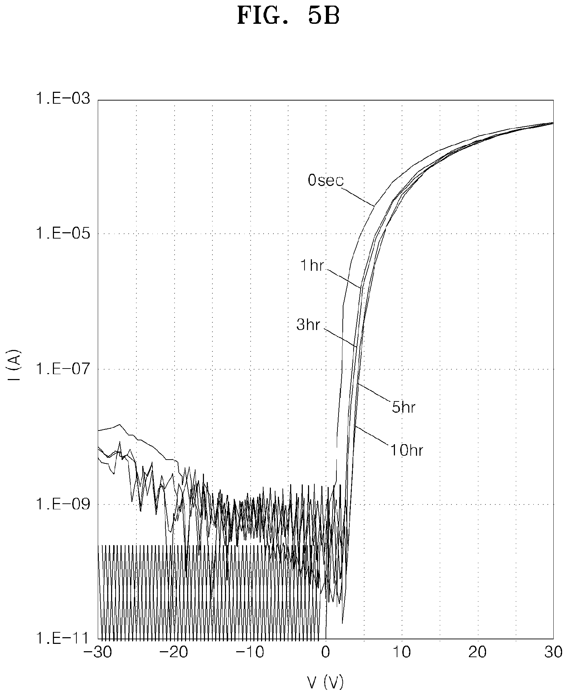

FIGS. 5A and 5B illustrate I-V characteristics of an oxide semiconductor TFT including first and second gates with respect to a bias voltage applying time periods, according to embodiments. Here, the first gate is electrically connected to the second gate to synchronize with the second gate. In more detail, FIG. 5A illustrates the I-V characteristics of the oxide semiconductor TFT with respect to an applying time period of a negative bias voltage (DC -20V) that is applied between the first and second gates and a source electrode at a temperature of 60°C. Also, FIG. 5B illustrates the I-V characteristics of the oxide semiconductor TFT with respect to an applying time period of a positive bias voltage (DC +20C) that is applied between the first and second gates and the source electrode at the temperature of 60°C. Here, Ga-In Zn Oxide is used as an oxide semiconductor, and first and second gate insulating layers are formed of silicon nitride and silicon oxide, respectively. Also, thicknesses of the first and second gate insulating layers are about 4000Å and about 2000Å, respectively. The first gate, the source electrode, and a drain electrode are formed of Mo on a lower surface of a channel layer, and the second gate is formed of In-Zn Oxide on an upper surface of the channel layer.

Referring to FIGS. 5A and 5B, in the oxide semiconductor TFT including the first and second gates, after the negative bias voltage is applied for 3 hours, a threshold voltage is changed by about +0.2V. After the positive bias voltage is applied for 3 hours, the threshold voltage is changed by about 2.7V.

As described above, compared to a single gate structure oxide semiconductor TFT, in a double gate structure oxide semiconductor TFT, when a negative bias voltage is applied, a variation in a threshold voltage is greatly reduced from 9.7V to 0.2V. When a positive bias voltage is applied, the variation in the threshold voltage is greatly reduced from 6.6V to 2.7V. Therefore, electric reliability of the double gate structure oxide semiconductor TFT is improved more than in the case of the single gate structure oxide semiconductor TFT. The improvement of the electric reliability of the double gate structure oxide semiconductor TFT is attributed to the following reasons. A voltage is simultaneously applied to first and second gates to disperse carriers in an active layer. Also, an electric field formed by the first gate overlaps with an electric field formed by the second gate to weaken a total electric field. In addition, silicon oxide constituting a second gate insulating layer moves a threshold voltage toward a positive direction, while silicon nitride constituting a first gate insulating layer moves the threshold voltage toward a negative direction.

The oxide semiconductor TFT of the present embodiment as described above may be applied to a driving circuit unit and a pixel unit of a display device.

FIG. 6 is a plan view of an oxide semiconductor TFT applied to a pixel unit of a display device, according to another embodiment. FIG. 7 is a cross-sectional view taken along line VI-VI' of FIG. 6, and FIG. 8 is a cross-sectional view taken along line VII-VII' of FIG. 6. Hereinafter, the descriptions related to the oxide semiconductor TFT of the present embodiment that are different from those related to the oxide semiconductor TFT of the previous embodiment will be mainly described.

Referring to FIGS. 6 through 8, a first gate 212 and the gate line 211 are formed on a substrate 200. The gate line 211 is electrically connected to the first gate 212 to apply a predetermined voltage to the first gate 212. A first gate insulating layer 210 is formed on the substrate 200 to cover the first gate 212 and the gate line 211. The first gate insulating layer 210 may be formed of a material that does not include oxygen, e.g., silicon nitride. A thickness of the first gate insulating layer 210 may be different from that of a second gate insulating layer 220. In detail, a thickness **d₁** of the first gate insulating layer 210 may be thicker than a thickness **d₂** of the second gate insulating layer 220.

A channel layer 216 is formed of an oxide semiconductor to a predetermined thickness on the first gate insulating layer 210 positioned on the first gate 212. The oxide semiconductor may be Zinc Oxide, Tin Oxide, Ga-In-Zn Oxide, In-Zn Oxide, In-Sn Oxide, or one of Zinc Oxide, Tin Oxide, Ga-In-Zn Oxide, In-Zn Oxide, and In-Sn Oxide that are doped with Al, Ni, Cu, Ta, Mo, Hf, or Ti. The channel layer 216 may be formed to a thickness between about 10nm and about 300nm.

A source electrode 218a and a drain electrode 218b are respectively formed on both sides of an upper surface of the channel layer 216 formed of the oxide semiconductor. The source electrode 218a is electrically connected to a data line 219. The second gate insulating layer 220 is formed to a predetermined thickness on the first gate insulating layer 210 to cover the channel layer 216 and the source and drain electrodes 218a and 218b. Here, the second gate insulating layer 220 may be formed of a material including oxygen, e.g., silicon oxide. The second gate insulating layer 220 is also formed to a different thickness from that of the first gate insulating layer 210. In detail, the thickness **d₂** of the second gate insulating layer 220 may be thinner than the thickness **d₁** of the first gate insulating layer 210.

A second gate 222 is formed on the second gate insulating layer 220. The second gate 222 is positioned above the channel layer 216. The second gate 222 may be formed to have a line width between 0.08µm and 100µm. As previously described, if a predetermined voltage is applied to the second gate 222, the second gate 222 inhibits a leakage current and increases an operating current in a turn-on state of the oxide semiconductor TFT.

A pixel electrode 250 is formed on the second gate insulating layer 220 to be electrically connected to the drain electrode 218b. For this purpose, as shown in FIG. 7, a first via hole 261 is formed in a portion of the second gate insulating layer 220 formed on the drain electrode 218b to expose the drain electrode 218b. Also, the pixel electrode 250 is connected to the drain electrode 218b through the first via hole 261. The pixel electrode 250 may be formed of a transparent conductive material such as Indium Tin Oxide (ITO) or Indium Zinc Oxide (IZO). The pixel electrode 250 and the second gate 222 may be simultaneously formed on the second gate insulating layer 220. In this case, the second gate 222 may be formed of the same material as the pixel electrode 250.

As shown in FIG. 8, the second gate 222 is formed to be electrically connected to the gate line 211. For this purpose, a second via hole 262 is formed in the first and second gate insulating layers 210 and 220 formed on the gate line 211 to expose the gate line 211. Also, the second gate 222 is connected to the gate line 211 through the second via hole 262. Therefore, the second gate 222 is electrically connected to the first gate 212 to electrically synchronize with the first gate 212.

It has been described in the present embodiment that the second gate 222 is electrically connected to the first gate 212. However, in an example not forming part of the invention the second gate 222 may be connected to an independent line (not shown) that is not electrically connected to the first gate 212. Here, the independent line may be formed on the substrate 200 or another material layer. In this case, a predetermined direct current (DC) voltage is applied to the second gate 222 through the independent line separately from the first gate 212.

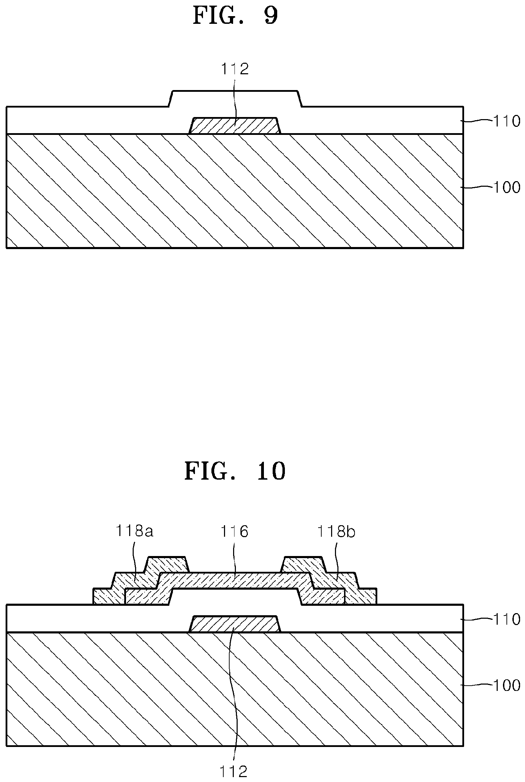

A method of manufacturing an oxide semiconductor TFT according to an embodiment will now be described. FIGS. 9 through 11 are cross-sectional views illustrating a method of manufacturing the oxide semiconductor TFT including the double gates, according to an embodiment.

Referring to FIG. 9, the first gate 112 is formed on the substrate 100. Here, a predetermined gate metal may be deposited on the substrate 100 and then patterned to form the first gate 112. In this process, the gate line 211 in FIG. 6 may be formed on the substrate 100 together with the first gate 112 to be electrically connected to the first gate 112. The first gate insulating layer 110 is formed on the substrate 100 to cover the first gate 112. Here, the first gate insulating layer 110 may be formed of a material that does not include oxygen, e.g., silicon oxide. Also, the first gate insulating layer 110 may be formed to a thicker thickness than that of the second gate insulating layer 120. In more detail, the thickness **d₁** of the first gate insulating layer 110 may be from about 2000Å to about µm, but is not limited thereto.

Referring to FIG. 10, the channel layer 116 is formed of the oxide semiconductor on the first gate insulating layer 110. Here, the channel layer 116 is formed to be positioned above the first gate 112. The oxide semiconductor may be deposited to a predetermined thickness on the first gate insulating layer 110 and then patterned to form the channel layer 116. For example, the oxide semiconductor may be Zinc Oxide, Tin Oxide, Ga-In-Zn Oxide, In-Zn Oxide, In-Sn Oxide, or one of Zinc Oxide, Tin Oxide, Ga-In-Zn Oxide, In-Zn Oxide, and In-Sn Oxide that are doped with Al, Ni, Cu, Ta, Mo, Hf, or Ti. The channel layer 116 may be formed to a thickness between 10nm and 300nm but is not limited thereto. The source and drain electrodes 118a and 118b are formed on the both sides of the upper surface of the channel layer 116 formed of the oxide semiconductor. A predetermined metal layer may be formed on the first gate insulating layer 110 to cover the channel layer 116 and then patterned in order to form the source and drain electrodes 118a and 118b. Here, the predetermined metal layer may have a single layer structure or a multilayer structure. The predetermined metal electrodes 118a and 118b after the source and drain electrodes 118a and 118b are formed.

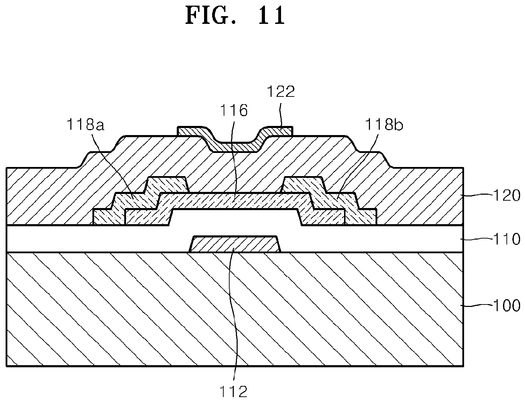

Referring to FIG. 11, the second gate insulating layer 120 is formed on the first gate insulating layer 110 to cover the channel layer 116 and the source and drain electrodes 118a and 118b. Here, the second gate insulating layer 120 may be formed of a different material from that of which the first gate insulating layer 110 is formed. In more detail, the second gate insulating layer 120 may be formed of a material including oxygen, e.g., silicon oxide. The second gate insulating layer 120 may be formed to a thinner thickness than that of the first gate insulating layer 110. In more detail, the thickness **d₂** of the second gate insulating layer 120 may be from about 500Å to about 5000Å, but is not limited thereto. The second gate 122 is formed on the second gate insulating layer 120 positioned on the channel layer 116. A predetermined gate metal may be on the second gate insulating layer 120 and then patterned to form the second gate 122. Here, the second gate 122 may be formed in a line width between about 0.08µm and about 100µm.

Although not shown in FIGS. 9 through 11, if the second gate 122 is to be formed to be connected to a gate line, the first and second gate insulating layers 110 and 120 positioned on the gate line may be etched to form a via hole so as to expose the gate line. Next, the second gate 122 may be formed on an inner wall of the via hole and the second gate insulating layer 120. Next, the second gate 122 may be formed on an inner wall of the via
hole and the second gate insulating layer 120. Here, the independent line may be formed on the substrate 100 or another material layer.

If a pixel electrode is to be further formed on the second gate insulating layer 120, the pixel electrode and the second gate 122 may be formed simultaneously. In detail, a via hole is formed in a portion of the second gate insulating layer 120 positioned on the drain electrode 118b to expose the drain electrode 118b. A predetermined material is deposited to cover the second gate insulating layer 120 and the via hole and then patterned so as to form the second gate 122 and the pixel electrode. Therefore, the second gate 122 may be formed on a portion of the second gate insulating layer 120 positioned on the channel layer 116, and the pixel electrode may be formed on an inner wall of the via hole and the second gate insulating layer 120. Here, the second gate 122 and the pixel electrode may be formed of a transparent conductive material such as ITO or IZO.

An oxide semiconductor TFT having a Bottom Gate Back Channel Etch (BCE) structure has been described in the above embodiments. However, this is only an example, and thus the above embodiments may be applied to oxide semiconductor TFTs having other types of structures, e.g., a Bottom Gate Etch Stop structure, a Top Gate structure, etc. In detail, in the oxide semiconductor TFT having the Bottom Gate Etch Stop structure, an etch stop layer is formed on an upper surface of a channel layer formed between source and drain electrodes. In the oxide semiconductor TFT having the Top Gate structure, a first gate and a first gate insulating layer are positioned on a channel layer, and a second gate and a second gate insulating layer are positioned underneath the channel layer.

It should be understood that the exemplary embodiments described therein should be considered in a descriptive sense only and not for purposes of limitation. Descriptions of features or aspects within each embodiment should typically be considered as available for other similar features or aspects in other embodiments.

## Claims

1. An oxide semiconductor thin film transistor (TFT) comprising:
a channel layer (116,216);
a first gate (112,212);
a second gate (122,222);
a first gate insulating layer (110,210) formed between the channel layer and the first gate; and
a second gate insulating layer (120,220) formed between the channel layer and the second gate,
wherein the first and second gate insulating layers (110,120,210,220) are formed of different materials, the first gate insulating layer (110,120) being formed of a material that does not include oxygen and the second gate insulating layer being formed of a material that does include oxygen;
wherein the second gate (122,222) is electrically connected to the first gate (112,212) to synchronize with the first gate.

2. An oxide semiconductor thin film transistor according to claim 1, wherein the first and second gates (112,122,212,222) are formed one on the upper surface of the channel layer and one under the lower surface of the channel layer aligned with the gate on the upper surface.

3. The oxide semiconductor TFT of claim 1 or 2, wherein the first gate insulating layer is formed of silicon nitride, and the second gate insulating layer is formed of silicon oxide.

4. The oxide semiconductor TFT of claim 3, wherein the first gate insulating layer (110,210) is formed to be thicker than the second gate insulating layer.

5. The oxide semiconductor TFT of claim 4, wherein a thickness of the first gate insulating layer (110,210) is from 2000Å to about 1µm, and a thickness of the second gate insulating layer is from 500Å to about 5000Å.

6. The oxide semiconductor TFT of any preceding claim, further comprising source and drain electrodes (118,218) formed on both sides of an upper surface of the channel layer, or on both sides of a lower surface of the channel layer.

7. The oxide semiconductor TFT of any preceding claim, wherein the oxide semiconductor is one of Zinc Oxide, Tin Oxide, Ga-In-Zn Oxide, In-Zn Oxide, In-Sn Oxide, and one of Zinc Oxide, Tin Oxide, Ga-In-Zn Oxide, In-Zn Oxide, and In-Sn Oxide that are doped with one of Al, Ni, Cu, Ta, Mo, Hf, and Ti.

## Patentansprüche

1. Oxid-Halbleiter-Dünnschichttranssistor (TFT), umfassend:
eine Kanalschicht (116, 216);
ein erstes Gate (112, 212);
ein zweites Gate (122, 222);
eine erste Gate-Isolationsschicht (110, 210), die zwischen der Kanalschicht und dem ersten Gate ausgebildet ist; und
eine zweite Gate-Isolationsschicht (120, 220), die zwischen der Kanalschicht und dem zweiten Gate ausgebildet ist;
wobei die erste und die zweite Gate-Isolationsschicht (110, 120, 210, 220) aus unterschiedlichen Materialien bestehen, wobei die erste Gate-Isolationsschicht (110, 210) aus einem Material besteht, das keinen Sauerstoff aufweist, und wobei die zweite Gate-Isolationsschicht aus einem Material besteht, das Sauerstoff aufweist;
wobei das zweite Gate (122, 222) zur Synchronisation mit dem ersten Gate mit dem ersten Gate (112, 212) elektrisch verbunden ist.

2. Oxid-Halbleiter-Dünnschichttranssistor nach Anspruch 1, wobei die ersten und zweiten Gates (112, 122, 212, 222) mit einem Gate auf der oberen Oberfläche der Kanalschicht und einem Gate unter der unteren Oberfläche der Kanalschicht ausgebildet sind, ausgerichtet mit dem Gate auf der oberen Oberfläche.

3. Oxid-Halbleiter-TFT nach Anspruch 1 oder 2, wobei die erste Gate-Isolationsschicht aus Siliziumnitrid besteht, und wobei die zweite Gate-Isolationsschicht aus Siliziumoxid besteht.

4. Oxid-Halbleiter-TFT nach Anspruch 3, wobei die eine erste Gate-Isolationsschicht (110, 210) dicker als die zweite Gate-Isolationsschicht ausgebildet ist.

5. Oxid-Halbleiter-TFT nach Anspruch 4, wobei eine Dicke der ersten Gate-Isolationsschicht (110, 210) zwischen 2000 Å und etwa 1 µm liegt, und wobei eine Dicke der zweiten Gate-Isolationsschicht zwischen 500 Å und etwa 5000 Å liegt.

6. Oxid-Halbleiter-TFT nach einem der vorstehenden Ansprüche, ferner umfassend Source- und Drain-Elektroden (118, 218), die auf beiden Seiten einer oberen Oberfläche der Kanalschicht oder auf beiden Seiten einer unteren Oberfläche der Kanalschicht ausgebildet sind.

7. Oxid-Halbleiter-TFT nach einem der vorstehenden Ansprüche, wobei der Oxidhalbleiter eines der folgenden ist: Zinkoxid, Zinnoxid, Ga-In-Zn-Oxid, In-Zn-Oxid, In-Sn-Oxid, und eines der folgenden: Zinkoxid, Zinnoxid, Ga-In-Zn-Oxid, In-Zn-Oxid, In-Sn-Oxid, dotiert mit einem der folgenden: Al, Ni, Cu, Ta, Mo, Hf und Ti.

## Revendications

1. Transistor en couches minces (TFT) à semi-conducteur d'oxyde comprenant :
une couche de canal (116, 216) ;
une première grille (112, 212) ;
une seconde grille (122, 222) ;
une première couche isolante de grille (110, 210) formée entre la couche de canal et la première grille ; et
une seconde couche isolante de grille (120, 220) formée entre la couche de canal et la seconde grille,
les première et seconde couches isolantes de grille (110, 120, 210, 220) étant formées de différents matériaux, la première couche isolante de grille (110, 120) étant formée d'un matériau qui ne contient pas d'oxygène et la seconde couche isolante de grille étant formée d'un matériau qui contient de l'oxygène ;
la seconde grille (122, 222) étant connectée électriquement à la première grille (112, 212) pour se synchroniser avec la première grille.

2. Transistor en couches minces à semi-conducteur d'oxyde selon la revendication 1, les première et seconde grilles (112, 122, 212, 222) étant formées l'une sur la surface supérieure de la couche de canal et l'autre sous la surface inférieure de la couche de canal alignée avec la grille sur la surface supérieure.

3. TFT à semi-conducteur d'oxyde selon la revendication 1 ou 2, la première couche isolante de grille étant formée de nitrure de silicium, et la seconde couche isolante de grille étant formée d'oxyde de silicium.

4. TFT à semi-conducteur d'oxyde selon la revendication 3, la première couche isolante de grille (110, 210) étant formée pour être plus épaisse que la seconde couche isolante de grille.

5. TFT à semi-conducteur d'oxyde selon la revendication 4, une épaisseur de la première couche isolante de grille (110, 210) étant comprise entre 2 000 Å et environ 1 µm, et une épaisseur de la seconde couche isolante de grille étant comprise entre 500 Å et environ 5 000 Å.

6. TFT à semi-conducteur d'oxyde selon l'une quelconque des revendications précédentes, comprenant en outre des électrodes de source et de drain (118, 218) formées sur les deux côtés d'une surface supérieure de la couche de canal, ou sur les deux côtés d'une surface inférieure de la couche de canal.

7. TFT à semi-conducteur d'oxyde selon l'une quelconque des revendications précédentes, le semi-conducteur d'oxyde étant de l'oxyde de zinc, oxyde d'étain, oxyde de Ga-In-Zn, oxyde d'In-Zn, oxyde d'In-Sn et de l'oxyde de zinc, oxyde d'étain, oxyde de Ga-In-Zn, oxyde d'In-Zn ou oxyde d'In- Sn dopé à Al, Ni, Cu, Ta, Mo, Hf, ou Ti.
